# EUROPÄISCHE PATENTSCHRIFT

(11) **EP 3 928 349 B1**
(45) Veröffentlichungstag und Bekanntmachung des Hinweises auf die Patenterteilung: **20.03.2024**
(21) Anmeldenummer: 20704519.6
(22) Anmeldetag: 10.02.2020
(51) Int. Cl.: H01L 21/687, C23C 16/458, H01L 21/67, C23C 16/46, C23C 16/455

(54) **CVD-REAKTOR MIT MITTELN ZUR LOKALEN BEEINFLUSSUNG DER SUSZEPTORTEMPERATUR**
CVD REACTOR WITH MEANS FOR LOCALLY INFLUENCING THE SUSCEPTOR TEMPERATURE
BÂTI CVD AVEC MOYENS DE MODIFICATION LOCALE DE LA TEMPÉRATURE DU SUPPORT

(30) Priorität: 21.02.2019 DE 102019104433
(43) Veröffentlichungstag der Anmeldung: 29.12.2021
(60) Teilanmeldung: 24151152.6
(73) Patentinhaber: Aixtron SE, 52134 Herzogenrath (DE)
(72) Erfinder: LAUFFER, Peter Sebald, 52070 Aachen (DE)
(74) Vertreter: Grundmann, Dirk
(86) Internationale Anmeldenummer: PCT/EP2020/053289
(87) Internationale Veröffentlichungsnummer: WO 2020/169385

(56) Entgegenhaltungen:
- DE-A1- 10 064 942
- DE-A1-102007 026 348
- DE-A1-102009 044 276
- DE-A1-102017 105 947
- US-A- 5 155 336
- US-A- 6 001 183
- US-A1- 2012 003 389
- US-A1- 2018 002 830
- US-B2- 8 249 436

## Beschreibung

### Gebiet der Technik

Die Erfindung betrifft eine Vorrichtung zur thermischen Behandlung von Substraten mit einem von einer Heizeinrichtung beheizbaren und von einem Drehantrieb um eine Drehachse drehantreibbaren Suszeptor zur Aufnahme mindestens eines Substrates.

Die Erfindung betrifft darüber hinaus ein Verfahren zum thermischen Behandeln von Substraten, bei dem ein Suszeptor mindestens ein Substrat trägt, von einer Heizeinrichtung beheizt wird und um eine Drehachse drehangetrieben wird.

### Stand der Technik

Die US 8,249,436 B2 beschreibt eine Vorrichtung und ein Verfahren, bei dem einem um eine Drehachse rotierenden Suszeptor mittels eines gepulsten Laserstrahls lokal beschränkt Wärme zugeführt wird.

Vorrichtungen und Verfahren der vorbezeichneten Art sind auch bekannt, beispielsweise aus der DE 10 2009 044 276 A1. Eine Vorrichtung der in Rede stehenden Art wird von einem CVD-Reaktor verkörpert, der ein gasdichtes Gehäuse besitzt, in dem sich eine Prozesskammer befindet. Der Boden der Prozesskammer wird von einem um eine Drehachse drehantreibbaren Suszeptor ausgebildet. Auf dem Suszeptor befinden sich in gleichmäßiger Umfangsverteilung um ein zentrales Gaseinlassorgan Substrathalter, die jeweils ein Substrat tragen und die von einem Spülgasfluss drehangetrieben in der Schwebe gehalten werden. Der Suszeptor dreht sich oberhalb einer Heizeinrichtung, die eine Induktionsspule ist, die kühlmittelgekühlt ist. Die Temperatur der Unterseite des Suszeptors wird über einen ersten Pyrometer gemessen. Die Temperatur der auf dem Substrathalter aufliegenden Substrate wird mit einem zweiten Pyrometer gemessen. Die Induktionsspule erzeugt ein hochfrequentes Wechselfeld, welches innerhalb des aus Graphit gefertigten Suszeptors Wirbelströme erzeugt, so dass sich der Suszeptor auf eine Prozesstemperatur erwärmen kann. Aufgrund fertigungstechnischer Unzulänglichkeiten besitzt der Werkstoff des Suszeptors keine homogen verteilte elektrische Leitfähigkeit, so dass sich Zonen mit geringer elektrischer Leitfähigkeit und Zonen mit hoher elektrischer Leitfähigkeit ausbilden. Den im Suszeptor induzierten Wirbelströmen wird daher lokal ein unterschiedlicher elektrischer Widerstand entgegengesetzt, so dass sich der Suszeptor lokal unterschiedlich erwärmt. Der Temperaturunterschied innerhalb des Suszeptors kann bei einer mittleren Temperatur von 650°C 5 bis 8 K betragen. Es ist eine technologische Herausforderung, das laterale Temperaturprofil auf der Suszeptoroberseite, auf der die Substrate angeordnet sind, so homogen wie möglich zu gestalten.

Aus der DE 10 2011 055 061 A1 ist ein CVD-Reaktor bekannt, bei dem in einen Spalt zwischen einer Heizeinrichtung und der Unterseite eines Suszeptors ein Gasgemisch aus einem stark wärmeleitenden und einem schwach wärmeleitenden Gas eingespeist werden kann.

Zum Stand der Technik gehören auch die folgenden Druckschriften: DE 10 2005 056 536 A1, DE 10 2009 043 960 A1, DE 10 2011 053 498 A1, DE 10 2013 109 155 A1, DE 10 2014 104 218 A1, DE 10 2017105 333 A1, US 2018/0182635 A1, US 5 468 299 A und DE 10 2007 026 348 A1.

### Zusammenfassung der Erfindung

Der Erfindung liegt die Aufgabe zugrunde, Maßnahmen anzugeben, mit denen sich lokale Temperaturunterschiede des Suszeptors kompensieren lassen.

Gelöst wird die Aufgabe durch die in den Ansprüchen angegebene Erfindung.

Zunächst und im Wesentlichen wird vorgeschlagen, dass Mittel vorgesehen sind, mit denen der Wärmezufluss beziehungsweise die Wärmeabfuhr zum oder vom Suszeptor an zumindest einer örtlich beschränkten Wärmebeeinflussungszone periodisch gepulst verändert wird. Die Mittel arbeiten synchronisiert mit der Drehbewegung des Suszeptors. Mit dem erfindungsgemäßen Verfahren wird der Wärmetransport von oder zum Suszeptor lokal beschränkt und mit der Drehbewegung des Suszeptors synchronisiert beeinflusst. Bezogen auf das Gehäuse der Vorrichtung liegen die Wärmebeeinflussungszonen örtlich fest. Der azimutale Winkelbereich, über den sich eine Wärmebeeinflussungszone erstreckt, ist bevorzugt geringer, als der Winkelbereich um das Drehzentrum des Suszeptors, der von einem Substrathalter des Suszeptors eingenommen wird. Die Pulsdauer, mit der der Wärmebeeinflussungszone des sich drehenden Suszeptors Wärme zu- oder abgeführt wird, ist so gewählt, dass die Wärme nur an den Stellen auf den sich drehenden Suszeptor übertragen wird, die sich aufgrund einer örtlich höheren elektrischen Leitfähigkeit des Materials des Suszeptors nicht ausreichend genug aufheizen, also an kälteren Stellen. Die Vorrichtung besitzt eine Steuerung, die mit einer Drehwinkelerfassung zusammenwirkt, mit der der lokale Drehwinkel des Suszeptors erfassbar ist. Die Steuerung synchronisiert die Wärmebeeinflussung mit der Drehbewegung des Suszeptors beispielsweise derart, dass bei den einzelnen Umläufen des Suszeptors immer dieselbe Stelle wärmebeaufschlagt wird. Der - bezogen auf das Gehäuse - ortsfeste Wärmefluss beaufschlagt somit bevorzugt bei jeder Umdrehung des Suszeptors jeweils dieselbe Wärmebeeinflussungszone des Suszeptors. Erfindungsgemäß wird vorgeschlagen, dass im Bereich einer Wärmebeeinflussungszone die Wärmeleiteigenschaft eines Mediums periodisch verändert wird. Es ist insbesondere vorgesehen, dass sich das Medium zwischen dem Suszeptor und einem Temperieraggregat erstreckt. Besonders bevorzugt wird vorgeschlagen, dass im Bereich einer Wärmebeeinflussungszone die Wärmeleiteigenschaft von zwischen dem Suszeptor und einem Kühlaggregat angeordneter Materie periodisch gepulst beeinflusst wird, wobei die Periodendauer die Umlaufzeit einer Umdrehung des Suszeptors ist und die Pulsweite geringer ist, als die Umlaufdauer. Hierzu ist insbesondere vorgesehen, dass sich zwischen dem Suszeptor und dem Temperieraggregat ein Spalt erstreckt, durch den ein Spülgasfluss fließt. Es können ein oder mehrere lokale Einspeiseöffnungen in dem Spalt vorgesehen sein, durch die ein Temperiergas in den Spalt eingespeist wird. Durch den Spalt kann permanent ein Spülgas mit einer ersten Wärmeleitfähigkeit strömen. Durch die Einspeiseöffnung wird periodisch gepulst lokal beschränkt ein zweites Spülgas eingespeist, welches eine vom ersten Spülgas verschiedene Wärmeleitfähigkeit aufweist. Es ist insbesondere vorgesehen, dass das erste, permanent durch den Spalt strömende Spülgas Wasserstoff ist, also ein Gas mit einer hohen Wärmeleitfähigkeit, und dass durch die Einspeiseöffnung Stickstoff, also ein Gas mit einer niedrigeren Wärmeleitfähigkeit, eingespeist wird. Es können aber auch Paare anderer Gase, beispielsweise Helium und Argon verwendet werden. Das Kühlaggregat wird bevorzugt von der flüssigkeitsgekühlten Induktionsspule gebildet, mit der der Suszeptor beheizt wird. Mit der insbesondere spiralförmig in einer Ebene parallel zur Erstreckungsebene des Suszeptors angeordneten Induktionsspule werden innerhalb des aus Graphit oder einem anderen wärmeleitfähigen Material bestehenden Suszeptors Wirbelströme erzeugt. Die lokale Größe der Wirbelströme hängt von der geringfügig wechselnden Wärmeleitfähigkeit des Materials des Suszeptors ab, so dass das von der Induktionsspule erzeugte elektromagnetische Wechselfeld einen örtlich variierenden Energiefluss in dem Suszeptor erzeugt, der örtliche Temperaturdifferenzen zur Folge hat. Zur Ausbildung des oben genannten Spaltes, in dem das Temperiergas eingespeist wird, kann eine Platte vorgesehen sein, die sich mit geringem Spaltabstand zu einer Unterseite des Suszeptors zwischen Suszeptor und Induktionsspule erstreckt. Ein derartiger Spalt ist im Stand der Technik vorgesehen, um eine Diffusionsbarriere auszubilden. Durch den Spalt strömt von radial innen her in Richtung auf ein radial außen angeordnetes Gasauslassorgan ein Spülgasfluss, der verhindert, dass das Prozessgas, welches in die oberhalb des Suszeptors angeordnete Prozesskammer eingespeist wird, in den Bereich eindringt, in dem sich die Induktionsspule befindet. In diese von einem permanenten Gasstrom gebildete Diffusionsbarriere wird das Temperiergas eingespeist. Die Strömungsgeschwindigkeit, mit der das Spülgas durch den Spalt hindurchströmt, ist größer, als die Umlaufgeschwindigkeit des Suszeptors auf Höhe des radial äußeren Randes der Substrathalter. Der Spülgasfluss durch den Spalt ist insbesondere so groß, dass beim Überlaufen eines Suszeptors über die Wärmebeeinflussungszone ein vollständiger Gaswechsel im Spalt stattfindet. Anstelle eines periodischen Zuschaltens eines Temperiergases kann aber auch vorgesehen sein, dass durch die Einspeiseöffnung ein gleichbleibender Gasstrom hindurchströmt, der von einem Ventil gesteuert entweder ein Gasstrom des ersten Gases oder des zweiten Gases ist. Hierzu ist es insbesondere von Vorteil, wenn an der Einspeiseöffnung eine Gasleitung mündet, in die von einem Ventil gesteuert wahlweise ein Gas mit einer hohen Wärmeleitfähigkeit oder ein Gas mit einer geringeren Wärmeleitfähigkeit eingespeist wird. In einer Weiterbildung der Erfindung wird vorgeschlagen, dass mehrere Wärmebeeinflussungszonen in Umfangsrichtung um das Zentrum des Suszeptors, das mit der Drehachse des Suszeptors zusammenfällt, angeordnet sind. In Kombination damit oder gesondert kann aber auch vorgesehen sein, dass mehrere Wärmebeeinflussungszonen in Radialrichtung, bezogen auf das Drehzentrum des Suszeptors, hintereinander angeordnet sind, wobei diese Wärmebeeinflussungszonen entweder von Wärmestrahlern mit Wärme versorgt oder Zonen veränderbarer Wärmeleiteigenschaften sind. In einer Weiterbildung der Erfindung kann vorgesehen sein, dass die Wärmebeeinflussungszone auf einer Umfangslinie liegt, auf der sich die Substrathalter befinden. Dies hat zur Folge, dass nur der radial äußere Bereich des sich drehenden Substrathalters von der Wärmebeeinflussungszone beeinflusst wird, so dass mit dieser Maßnahme auch ein Temperaturprofil auf dem Substrathalter eingestellt werden kann. So ist insbesondere vorgesehen, dass mit den Mitteln zur Beeinflussung des Wärmetransportes nur der radial äußere Rand des Substrathalters beeinflusst wird. Die Temperaturmessstellen, mit denen insbesondere an der Unterseite des Suszeptors die Oberflächentemperatur des Suszeptors gemessen werden kann, können in unterschiedlichen Radialpositionen angeordnet sein. Es ist insbesondere vorgesehen, dass radial innerhalb und radial außerhalb einer Wärmebeeinflussungszone eine Temperatur-messstelle angeordnet ist. Es ist insbesondere vorgesehen, dass an den Temperaturmessstellen mit Hilfe eines Pyrometers die Oberflächentemperatur des Suszeptors gemessen wird. Es ist insbesondere vorgesehen, dass hierfür ein Lichtwellenleiter verwendet wird.

Gemäß einer Variante der Erfindung wird vorgeschlagen, dass zur Beeinflussung des radialen Temperaturprofils eines Substrates, das von einem um eine Substrathalter-Drehachse drehangetriebenen Substrathalters getragen wird, die Wärmebeeinflussungszone radial versetzt zu einer Umlaufbahn der Substrathalter-Drehachse um das Zentrum des drehangetriebenen Suszeptors liegt. Dabei wird insbesondere vorgeschlagen, dass die Wärmebeeinflussungszone - bezogen auf die Drehachse des Suszeptors - radial innerhalb der Umlaufbahn oder bevorzugt radial außerhalb der Umlaufbahn liegt. Es ist hier insbesondere vorgesehen, dass das Medium, dessen Wärmeleiteigenschaft variiert wird, ein Gas ist, das sich zwischen Suszeptor und dem Temperieraggregat befindet, wobei als Temperieraggregat eine mit einem Kühlmittel gekühlte RF-Induktionsspule in Betracht kommt. In einer weiteren Variante ist vorgesehen, dass die Wärmebeeinflussungszone genau auf der Umlaufbahn der Substrathalter-Drehachse liegt. Bei diesen Varianten der Erfindung braucht die Wärmeleiteigenschaft nicht periodisch gepulst verändert werden. Es ist insbesondere von Vorteil, wenn der Substrathalter genau ein Substrat trägt, das eine kreisrunde Gestalt aufweist, wobei der Mittelpunkt des Substrates in der Substrathalter-Drehachse liegt. Mit diesen Varianten kann gezielt ein radiales Temperaturprofil des Substrates eingestellt werden. Zur Beeinflussung der Wärmeleiteigenschaft des zwischen Suszeptor und Temperieraggregat angeordneten Mediums ist insbesondere vorgesehen, dass durch eine radial außerhalb der Umlaufbahn angeordnete, radial innerhalb der Umlaufbahn angeordnete oder auf der Umlaufbahn angeordnete Gasaustrittsöffnung ein Temperiergas in einen Spalt zwischen Suszeptor und Temperieraggregat oder zwischen Suszeptor und einer zwischen Suszeptor und Temperieraggregat angeordneten Platte eingespeist wird. Dabei kann vorgesehen sein, dass die Strömungsrichtung des Temperiergases in Radialrichtung weg von der Umlaufbahn der Substrathalter-Drehachse weist. Bei einer radial außerhalb der Umlaufbahn angeordneten Gasaustrittsöffnung erfolgt die Strömungsrichtung dann in Radialauswärtsrichtung. Bei einer radial innerhalb der Umlaufbahn angeordneten Gasaustrittsöffnung ist die Strömungsrichtung dann nach radial innen gerichtet. Es ist aber auch möglich, dass die Strömungsrichtung auch bei einer radial innerhalb der Umlaufbahn angeordneten Gasaustrittsöffnung in Radialauswärtsrichtung - bezogen auf die Substrathalter-Drehachse - gerichtet ist.

### Kurze Beschreibung der Zeichnungen

Ausführungsbeispiele der Erfindung werden nachfolgend anhand beigefügter Zeichnungen erläutert. Es zeigen:
- Fig. 1: schematisch als Längsschnitt einen CVD-Reaktor mit einem darin angeordneten Suszeptor 5,
- Fig. 2: eine Darstellung gemäß Figur 1 eines ersten Ausführungsbeispiels der Erfindung mit einem Suszeptor 5,
- Fig. 3: eine Draufsicht auf den Suszeptor 5 des ersten Ausführungsbeispiels der Erfindung,
- Fig. 4: eine Darstellung gemäß Figur 1 eines zweiten Ausführungsbeispiels der Erfindung,
- Fig. 5: die Draufsicht auf den Suszeptor 5 des zweiten Ausführungsbeispiels der Erfindung,
- Fig. 6: den zeitlichen Verlauf einer periodisch gepulsten Beeinflussung der Wärmezufuhr oder Wärmeabfuhr an einer Wärmebeeinflussungszone am Suszeptor 5,
- Fig. 7: eine Darstellung gemäß Figur 2 eines dritten Ausführungsbeispiels der Erfindung,
- Fig. 8: eine Darstellung gemäß Figur 2 eines vierten Ausführungsbeispiels der Erfindung,
- Fig. 9: eine Darstellung gemäß Figur 2 eines fünften Ausführungsbeispiels der Erfindung,
- Fig. 10: Darstellung gemäß Figur 2 eines siebten Ausführungsbeispiels der Erfindung,
- Fig. 11: eine Darstellung eines weiteren Ausführungsbeispiels gemäß Figur 4.

### Beschreibung der Ausführungsformen

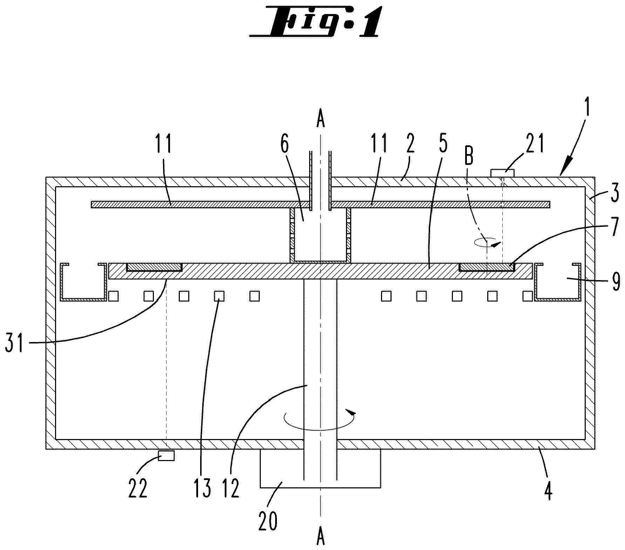

Ein CVD-Reaktor der gattungsgemäßen Art (siehe Figur 1) besitzt ein CVD-Reaktorgehäuse 1, welches gasdicht ist, aus Edelstahl bestehen kann und gekühlte Wände aufweisen kann. Es besitzt insbesondere einen Deckel 2, eine Seitenwand 3, die kreiszylinderförmig ausgebildet sein kann, und einen dem Deckel 2 gegenüberliegenden Boden 4. Deckel 2, Seitenwand 3 und Boden 4 können gekühlt sein.

Mit einem Gaseinlassorgan 6 können Prozessgase in eine Prozesskammer eingespeist werden. Die Prozesskammer wird nach obenhin durch eine Prozesskammerdecke 11 begrenzt und nach unten durch einen Suszeptor 5. Der Suszeptor 5 ist aus Graphit oder aus einem anderen elektrisch leitfähigen Material gefertigt und kann um einen Träger 12 um eine Achse A drehangetrieben werden. Hierzu dient ein Drehantrieb 20. Es sind nicht dargestellte Drehgeber vorgesehen, mit denen die jeweilige Drehwinkelposition des Suszeptors 5 bestimmt werden kann. Der Drehwinkel wird einer nicht dargestellten Steuerung mitgeteilt.

Unterhalb des Suszeptors 5 befindet sich eine Heizeinrichtung 13, die von einer flüssigkeitsgekühlten Induktionsspule ausgebildet wird, mit der ein RF-Feld erzeugt wird, welches innerhalb des Suszeptors 5 Wirbelströme induziert, die zu einer Erwärmung des Suszeptors auf eine Prozesstemperatur führen. Typischerweise liegen die Prozesstemperaturen im Bereich zwischen 600 und 1.000°C.

Die zur Prozesskammer weisende Oberseite des Suszeptors 5 besitzt eine Vielzahl von in Umfangsrichtung um das Zentrum des Suszeptors 5 angeordnete Taschen, in denen sich jeweils ein Substrathalter 7 befindet, der auf seiner zur Prozesskammer weisenden Oberseite ein Substrat trägt, das durch Einleiten von Prozessgasen, beispielsweise metallorganische Verbindungen der III-Hauptgruppe und Hydriden der V-Hauptgruppe mit einkristallinem Material beschichtet werden kann. Die Oberflächentemperatur der Substrate wird mit einem ersten Pyrometer 21 gemessen. Das Prozessgas durchströmt die Prozesskammer in Radialauswärtsrichtung und wird mittels eines ringförmig den Suszeptor 5 umgebenden Gasauslassorganes 9 abgeführt.

An einer Messstelle 31 wird mittels eines zweiten Pyrometers 22 die Oberflächentemperatur des Suszeptors 5 gemessen. Der vom ersten Pyrometer 21 und vom zweiten Pyrometer 22 gemessene Temperaturmesswert wird der nicht dargestellten Steuereinrichtung mitgeteilt. Mit einer Regeleinrichtung wird die in die Induktionsspule 13 eingespeiste Leistung derart geregelt, dass die Substrattemperatur oder die Suszeptortemperatur auf einem Sollwert gehalten wird.

Die in den Suszeptor 5 eingespeiste Wärmeenergie verlässt den Suszeptor einerseits durch die Prozesskammer hindurch zur Prozesskammerdecke 2 oder in radialer Richtung zur Seitenwand 3. Der größte Wärmestrom vom Suszeptor 5 geht jedoch in das die Induktionsspule 13 durchströmende Kühlwasser. Die Induktionsspule 13 bildet mit ihrem Kühlkanal 30 somit ein Kühlaggregat, um dem Suszeptor 5 Wärme zu entziehen.

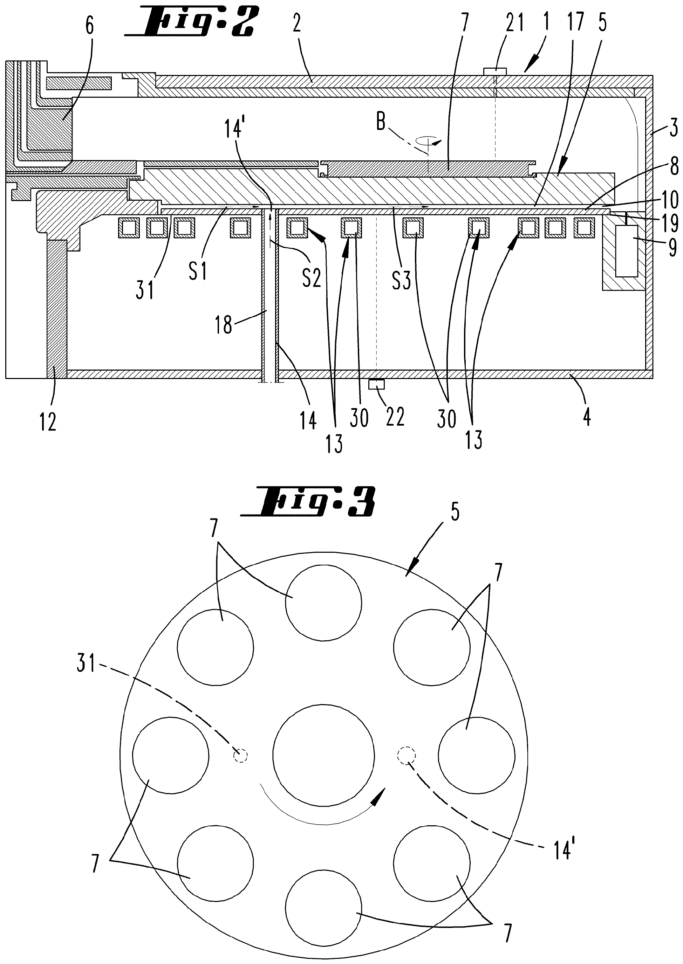

Bei dem in den Figuren 2 und 3 dargestellten Ausführungsbeispiel wird mit Hilfe einer Dichtplatte 8, die unterhalb des Suszeptors 5 angeordnet ist, ein gasdurchströmbarer Spalt 10 zwischen Suszeptor 5 und Heizeinrichtung 13 ausgebildet. Der radial äußere Rand der Dichtplatte 8 stützt sich auf einer Stufe 19 des Gasauslassorganes 9 ab. Von radial innen her kann in den Spalt 10 ein erster Gasfluss S1 einströmen, der eine Diffusionsbarriere ausbildet, mit der vermieden wird, dass Prozessgas in den Bereich des Reaktorgehäuses gelangt, in dem sich die Induktionsspule 13 befindet. Üblicherweise wird hierzu Wasserstoff verwendet.

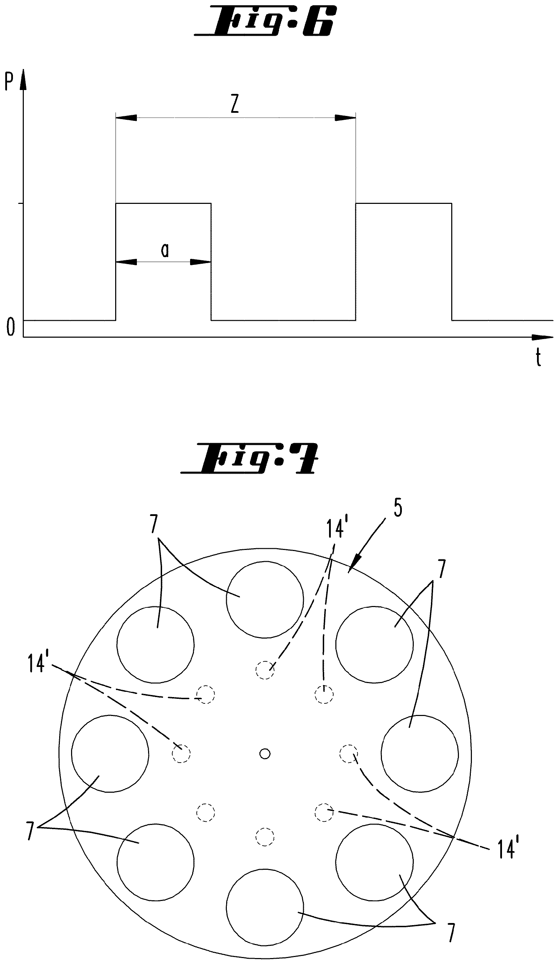

An zumindest einer Umfangsposition ist radial einwärts der Umfangszone, in der sich die Substrathalter 7 befinden, eine Einspeiseöffnung 14' vorgesehen, in der eine Gasleitung 14 mündet, mit der ein zweiter Gasfluss S2 in den Spalt 10 eingespeist werden kann. Hierzu wird bevorzugt Stickstoff verwendet. Mit einem nicht dargestellten Ventil kann ein gemäß Figur 6 gepulster Stickstoff-Gasstrom in den Spalt 10 eingespeist werden, so dass synchronisiert mit der Drehbewegung des Suszeptors 5 ein Temperiergas mit zeitlich verschiedenem Wärmeübertragungswiderstand durch den Spalt 10 unter den Substrathaltern 7 hindurchströmt. Der Gasstrom S3 wird von den beiden Gasströmen S1 und S2 gebildet und beeinflusst den Wärmetransport vom Suszeptor 5 zum Kühlaggregat 30. Der Gasstrom S2 ist derart mit der Drehbewegung des Suszeptors 5 synchronisiert, dass der Stickstoff als Gasfluss S2 nur dann dem Wasserstoffgasfluss S1 beigemischt wird, wenn sich ein bestimmter Substrathalter 7 der Mehrzahl der Substrathalter 7 über den Winkelbereich bewegt, durch den der den Gasstrom S2 aufweisende Gasstrom S3 strömt. Wegen der verminderten Wärmeleitfähigkeit des Stickstoffs gegenüber Wasserstoff, wird dem Suszeptor 5 unter diesem Substrathalter 7 weniger Wärme entzogen, als an anderen Stellen der übrigen Substrathalter 7. Lokale Kältestellen des Suszeptors 5 können somit kompensiert werden. Bei dieser Variante befindet sich die Wärmebeeinflussungszone auf einer vorgegebenen Radialposition bezogen auf die Drehachse A des Suszeptors 5 und an einer gehäusefesten Azimutalposition, bezogen auf die Substrathalter-Drehachse A. Da die Wärmebeeinflussung synchronisiert mit der Drehung des Suszeptors 5 erfolgt, ist die Wärmebeeinflussungszone 17 aber auch ortsfest, bezogen auf den Suszeptor 5, weil jeweils immer der Wärmetransport an demselben Substrathalter 7 beeinflusst wird.

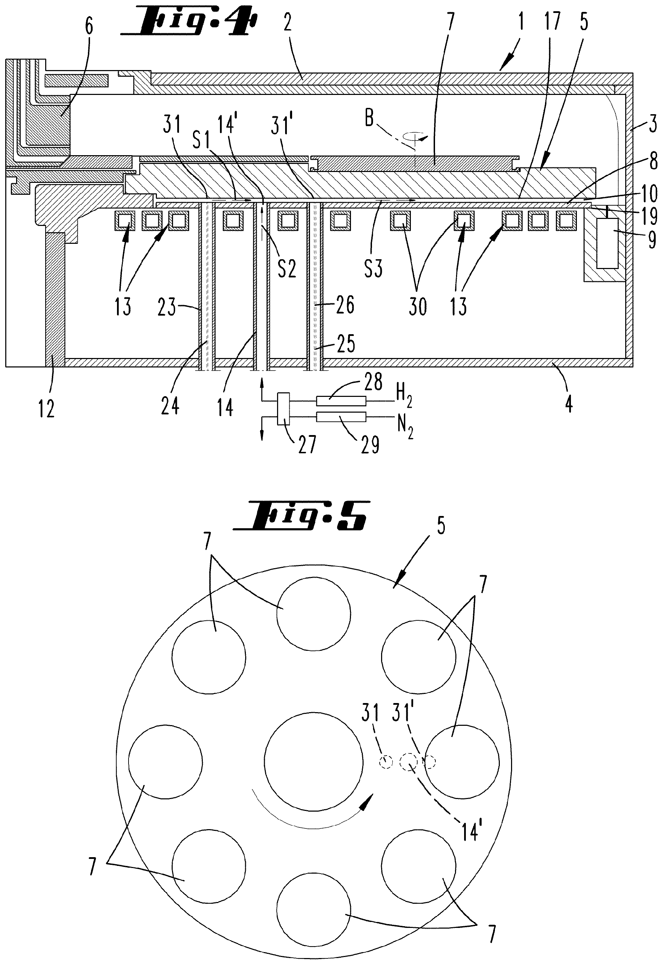

Die Figuren 3 und 4 zeigen ein zweites Ausführungsbeispiel der Erfindung. Hierbei ist zunächst vorgesehen, dass mit einem Umschaltventil 27 wahlweise Wasserstoff oder Stickstoff in die Gasleitung 14 eingespeist werden kann. Die Bezugsziffern 28 und 29 bezeichnen Massenflusskontroller, mit denen ein Stickstoffgasfluss oder ein Wasserstoffgasfluss eingestellt werden können. Bei dem Ventil 27 kann es sich um ein Umschaltventil handeln, das den jeweils anderen Gasfluss in einer "Vent-Leitung" leitet.

Diese Ventilanordnung kann auch bei den anderen Ausführungsbeispielen vorgesehen sein. Es kann aber auch nur ein Massenflusskontroller vorgesehen sein, der eine bestimmte Menge, z.B. Stickstoff, als zweiten Gasstrom S2 in den Spalt 10 einspeist.

Bei dem in den Figuren 3 und 4 dargestellten Ausführungsbeispiel ist ferner vorgesehen, dass sich die Einspeiseöffnung 14' in einer Umfangsringzone befindet, in der sich die Substrathalter 7 befinden, die jeweils auf einem Gaskissen drehangetrieben in Taschen der Oberseite des Suszeptors 5 angeordnet sind. Die Einspeiseöffnung 14' liegt insbesondere radial auswärts versetzt zum Zentrum des Substrathalters 7, so dass mit dem in dem Spalt 10 eingespeisten Temperiergas und dem sich dabei ausbildenden Gasfluss S3 nur die radial äußere Zone des Substrathalters 7 temperaturbeeinflusst wird. Wegen der Drehbewegung des Substrathalters 7 lässt sich hier die radial äußere Zone temperatursteuern und damit ein Temperaturprofil erzeugen.

Die Strömungsgeschwindigkeit des Gasflusses S3 in den Ausführungsbeispielen ist derart hoch, dass durch entsprechend kurze Pulse und eine Vielzahl von Pulsen mit gegebenenfalls unterschiedlichen Pulsweiten jeder Substrathalter 7 individuell temperaturbeeinflusst werden kann. Hierzu ist die Strömungsgeschwindigkeit des Gasflusses S3 unterhalb des Substrathalters 7 bevorzugt größer, als die Umlaufgeschwindigkeit des Suszeptors gemäß derjenigen am radial äußeren Rand des Substrathalters 7, bezogen auf das die Drehachse A des Suszeptors 5. Bevorzugt ist die Strömungsgeschwindigkeit S3 aber mindestens doppelt so groß wie diese Umlaufgeschwindigkeit. Die Gasströmung S3 beträgt bevorzugt etwa 20 cm/s.

Die Figur 4 zeigt ferner zwei Temperatur-Messstellen 31, 31', wobei die Temperatur-Messstelle 31 radial einwärts der Einspeiseöffnung 14' und die Temperatur-Messstelle 31' radial auswärts der Einspeiseöffnung 14' vorgesehen ist. Eine derartige Anordnung zweier Temperatur-Messstellen 31, 31' kann aber auch bei den anderen Ausführungsbeispielen, die in den Figuren 2 und 3 dargestellt sind, vorgesehen sein. Es ist insbesondere vorgesehen, dass an den Messstellen 31, 31' die Temperaturen über Pyrometer gemessen werden. Hierzu werden in Rohren 23, 25 Lichtwellenleiter 24, 26 geführt, die mit nicht dargestellten Pyrometern verbunden sind.

Bei dem in der Figur 7 dargestellten Ausführungsbeispiel sind mehrere Wärmebeeinflussungszonen und insbesondere mehrere Einspeiseöffnungen 14' in Umfangsrichtung um die Drehachse A des Suszeptors 5 angeordnet, wobei die Anordnung gleichmäßig verteilt ist.

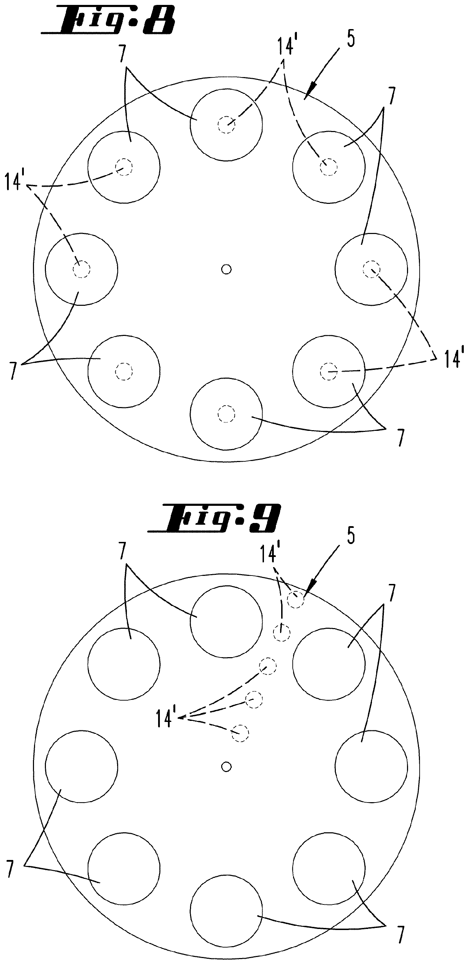

Das in der Figur 8 dargestellte vierten Ausführungsbeispiel zeigt mehrere Wärmebeeinflussungszonen beziehungsweise Einspeiseöffnungen 14', die jeweils auf Radialpositionen angeordnet sind, die im Zentrum einer Umfangszone liegen, in der sich die Substrathalter 7 befinden. In einer Variante des dort dargestellten Ausführungsbeispiels kann die Einspeiseöffnung 14' aber auch nur unter einigen der Substrathalter 7 oder nur unter einem der Substrathalter 7 angeordnet sein. Alternativ dazu kann die Einspeiseöffnung 14', die bei dem in der Figur 8 dargestellten Ausführungsbeispiel auf einer Umlaufbahn der Substrathalter-Drehachsen dargestellt ist, radial versetzt angeordnet sein. Die Einspeiseöffnung 14' kann somit - bezogen auf das Zentrum des Suszeptors 5 - radial innerhalb oder radial außerhalb der Umlaufbahn liegen. Die Strömungsrichtung des aus der einen oder den mehreren Einspeiseöffnungen 14' austretenden Temperiergases kann - bezogen auf die Suszeptor-Drehachse - sowohl radial einwärts als auch radial auswärts gerichtet sein.

Bei den in der Figur 9 dargestellten Ausführungsbeispiel sind mehrere Wärmebeeinflussungszonen beziehungsweise Einspeiseöffnungen 14' in Radialrichtung hintereinander angeordnet. Die Einspeiseöffnungen 14' können wahlweise betrieben werden. Die Substrathalter 7 sind um eine Substrathalter-Drehachse drehbar und tragen insbesondere jeweils nur ein kreisscheibenförmiges Substrat. Bei diesem Ausführungsbeispiel kann vorgesehen sein, dass der aus der ausgewählten Einspeiseöffnung 14' austretende Gasstrom eines Temperiergases ungepulst, d.h. konstant in einen Zwischenraum zwischen Suszeptorunterseite und Heizeinrichtung beziehungsweise Kühlaggregat austritt. Bei dieser Variante ist es aber auch möglich, das Temperiergas synchronisiert mit der Drehbewegung des Suszeptors und gepulst aus einer oder mehreren der Einspeiseöffnungen 14' austreten zu lassen. Es ist aber auch möglich, die Gasflüsse ungepulst durch die Einspeiseöffnungen 14' austreten zu lassen. Aus den Einspeiseöffnungen 14' können auch unterschiedliche Gasflüsse und/ oder unterschiedliche Gasarten gepulst oder nicht gepulst austreten. Hierzu ist es insbesondere von Vorteil, wenn mehrere Einspeiseöffnungen 14' umfangsversetzt - bezogen auf das Zentrum des Suszeptors 5 - angeordnet sind. Durch die verschiedenen Einspeiseöffnungen 14' können voneinander verschiedene Gase oder Mischungen verschiedener Gase auch in voneinander verschiedenen Pulsraten austreten.

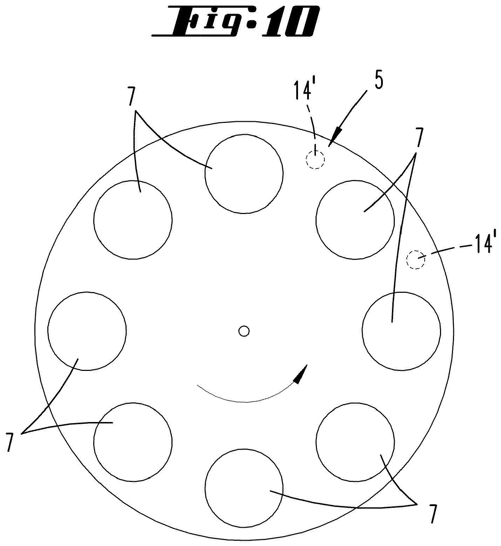

Bei dem in der Figur 10 dargestellten Ausführungsbeispiel ist eine Einspeiseöffnungen 14' im radial äußersten Bereich der Umfangszone angeordnet, in der sich die Substrathalter 7 befinden. Die Wärmebeeinflussungszone beziehungsweise Einspeiseöffnung 14' kann hier sogar radial außerhalb der Zone angeordnet sein, in der sich die Substrathalter 7 befinden.

Mindestens eine Wärmebeeinflussungszone 17 ist auf einen Winkelbereich um die Achse A beschränkt. Dieser azimutale Winkelbereich beträgt maximal 90, 60 oder 45 Grad oder bevorzugt maximal 30 Grad, 20 Grad oder maximal 15 Grad.

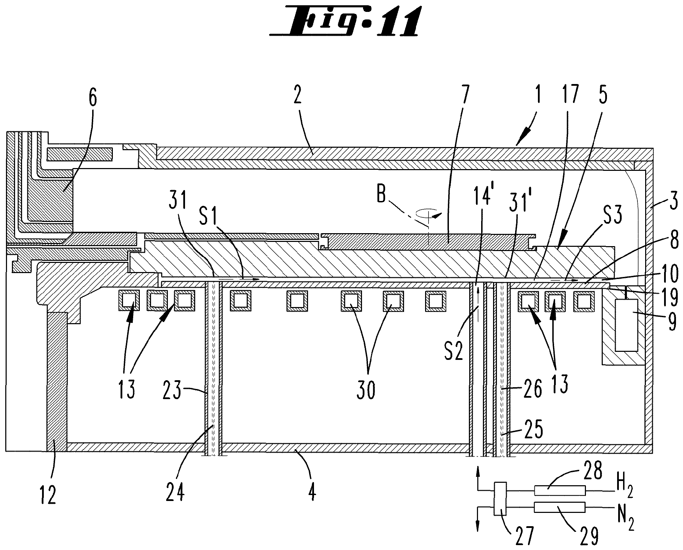

Das in der Figur 11 dargestellte Ausführungsbeispiel entspricht im Wesentlichen dem in der Figur 4 dargestellten Ausführungsbeispiel, wobei hier allerdings vorgesehen ist, dass die Einspeiseöffnung 14 radial außerhalb einer Substrathalter-Drehachse B liegt, um die der Substrathalter 7 drehangetrieben wird. Hierzu liegt der Substrathalter 7 auf einem Gaskissen auf, welches mit einem Drehimpuls in den Zwischenraum zwischen Substrathalter 7 und Suszeptor 5 derart eingespeist wird, dass der Substrathalter 7 in eine Drehung versetzt wird. Der Substrathalter 7 trägt hier bevorzugt ein Substrat, welches kreisförmig ist. Der Mittelpunkt und die Drehachse B fallen hier bevorzugt zusammen.

Der durch die Einspeiseöffnung 14 in den Spalt 10 eingespeiste Gasstrom durchströmt den Spalt 10 in Auswärtsrichtung. Der Gasstrom kann auch hier konstant oder synchronisiert mit der Drehung des Suszeptors 5 gepulst eingespeist werden.

Durch das Rohr 23, in dem sich ein Lichtwellenleiter 24 befinden kann, wird ein erster Gasstrom S1 in den Spalt 10 eingespeist, der beispielsweise Stickstoff sein kann. Das Rohr 23 ist, bezogen auf die Drehachse A des Suszeptors 5 radial einwärts einer Umlaufbahn der Substrathalter-Drehachse B angeordnet. In einem Bereich radial außerhalb dieser Umlaufbahn befindet sich die Einspeiseöffnung 14' zum Einspeisen eines Gases mit einer anderen Wärmeleitfähigkeit, beispielsweise Wasserstoff, so dass im radial äußeren Bereich des Substrathalters 7 im Spalt 10 eine andere Wärmetransporteigenschaft gegeben ist, als im Bereich des Zentrums, in dem sich die Substrathalter-Drehachse B befindet.

In einer nicht dargestellten Variante kann die Einspeiseöffnung 14' aber auch radial einwärts der Drehachse B des Substrathalters 7 angeordnet und näher an der Drehachse A des Suszeptors 5 liegen. Die Drehachse B des Substrathalters 7 beschreibt innerhalb des Reaktorgehäuses 1 einen Umlaufkreis um die Rotationsachse des Suszeptors 5. Die Einspeiseöffnung 14' kann auch auf dieser Umlaufbahn liegen.

### Liste der Bezugszeichen

| | | | |
|---|---|---|---|
| 1 | Reaktorgehäuse | 28 | Massenflusskontroller |
| 2 | Deckel | 29 | Massenflusskontroller |
| 3 | Seitenwand | 30 | Kühlkanal |
| 4 | Boden | 31 | Temperatur-Messstelle |
| 5 | Suszeptor | 31' | Temperatur-Messstelle |
| 6 | Gaseinlassorgan | | |
| 7 | Substrathalter | | |
| 8 | Dichtplatte | | |
| 9 | Gasauslassorgan | | |
| 10 | Spalt | | |
| 11 | Prozesskammerdecke | | |
| 12 | Träger | | |
| 13 | Heizeinrichtung | A | Suszeptor-Drehachse |
| 14 | Gasleitung | B | Substrathalter-Drehachse |
| 14' | Einspeiseöffnung | S | Strömungsrichtung |
| 17 | Wärmebeeinflussungszone | S1 | erster Gasfluss |
| 19 | Stufe | S2 | zweiter Gasfluss |
| 20 | Drehantrieb | S3 | dritter Gasstrom |
| 21 | erster Pyrometer | Z | Umlaufzeit |
| 22 | zweiter Pyrometer | | |
| 23 | Rohr | | |
| 24 | Lichtwellenleiter | a | Pulsweite |
| 25 | Rohr | | |
| 26 | Lichtwellenleiter | | |
| 27 | Umschaltventil | | |

## Patentansprüche

1. Vorrichtung zur thermischen Behandlung von Substraten mit einem von einer Heizeinrichtung (13) beheizbaren und von einem Drehantrieb (20) um eine Suszeptor-Drehachse (A) drehbaren Suszeptor (5), der zumindest einen Substrathalter (7) zur Aufnahme mindestens eines Substrates aufweist, mit Mitteln (14, 14') zur lokal beschränkten und mit der Drehbewegung des Suszeptors (5) synchronisierten Beeinflussung der Temperatur des Suszeptors (5), **dadurch gekennzeichnet, dass** die Mittel die Wärmeleiteigenschaft eines zwischen dem Suszeptor (5) und einem Temperieraggregat angeordneten Mediums periodisch gepulst verändern.

2. Vorrichtung nach Anspruch 1, **dadurch gekennzeichnet, dass** die Mittel (14, 14')im Bereich einer Wärmebeeinflussungszone (17) angeordnet sind, wobei die Wärmebeeinflussungszone (17) ein, bezogen auf die Suszeptor-Drehachse (A), radial innerhalb oder außerhalb oder auf einer Umlaufbahn der Substrathalter-Drehachse (B) um die Suszeptor-Drehachse (A) angeordneter Bereich ist.

3. Vorrichtung nach einem der vorhergehenden Ansprüche, **dadurch gekennzeichnet, dass** das Temperieraggregat ein Kühlaggregat (30) ist und/oder dass das Temperieraggregat von einem Kühlkanal einer RF-Induktionsspule (13) gebildet ist, wobei mit der RF-Induktionsspule (13) ein elektromagnetisches Wechselfeld erzeugt wird, welches in dem aus einem elektrisch leitfähigen Material des Suszeptors (5) Wirbelströme zu dessen Beheizung induziert.

4. Vorrichtung nach einem der vorhergehenden Ansprüche, **gekennzeichnet durch** eine Einspeiseöffnung (14') in einen Spalt (10) zwischen Suszeptor (5) und einem Temperieraggregat oder einem Kühlaggregat (30), durch die entweder periodisch gepulst oder mit einem konstanten Fluss ein Temperiergas eingespeisbar ist oder an der eine Gaszuleitung (14) mündet, in die mittels eines Umschaltventils (28) wahlweise ein Gas mit einer hohen Wärmeleitfähigkeit oder ein Gas mit einer geringeren Wärmeleitfähigkeit einspeisbar ist.

5. Vorrichtung nach Anspruch 4, **dadurch gekennzeichnet, dass** der Spalt (10) von einer zwischen der Heizeinrichtung (13) und der Unterseite des Suszeptors (5) angeordneten Dichtplatte (8) ausgebildet wird.

6. Vorrichtung nach einem der Ansprüche 2 bis 5, **dadurch gekennzeichnet, dass** mehrere Wärmebeeinflussungszonen (17) vorgesehen sind, in denen periodisch gepulst Wärme zu- oder abgeführt wird, wobei die Wärmebeeinflussungszonen (17) in voneinander verschiedenen Azimutalwinkeln - bezogen auf das Zentrum des Suszeptors (5) - angeordnet sind, wobei die Wärmebeeinflussungszone (17) auf einen Winkelbereich um die Achse (A) von maximal 90 Grad, 60 Grad, 45 Grad, 30 Grad oder 15 Grad beschränkt ist und/oder in unterschiedlichen Radialabständen - bezogen auf das Zentrum des Suszeptors (5) - angeordnet sind.

7. Vorrichtung nach einem der Ansprüche 2 bis 6, **dadurch gekennzeichnet, dass** zumindest eine Wärmebeeinflussungszone (17), an der periodisch gepulst Wärme zu- oder abgeführt wird, in einem Umfangsbereich um das Zentrum des Suszeptors (5) angeordnet ist, in welchem sich eine Mehrzahl von Substrathaltern befindet.

8. Vorrichtung nach einem der vorhergehenden Ansprüche, **gekennzeichnet durch** radial außerhalb und/oder radial innerhalb einer Wärmebeeinflussungszone angeordnete Temperatur-Messstellen (31, 31') zur Messung der Temperatur einer Oberfläche des Suszeptors (5).

9. Vorrichtung nach einem der Ansprüche 4 bis 8, **dadurch gekennzeichnet, dass** mehrere Einspeiseöffnungen (14') in voneinander verschiedenen Radialabständen zur Suszeptor-Drehachse (A) vorgesehen sind, wobei wahlweise ein durch ein oder mehrere Einspeiseöffnungen (14') ein oder mehrere Temperiergase eingespeist werden können.

10. Verfahren zum thermischen Behandeln von Substraten, bei dem ein Suszeptor (5) mindestens ein Substrat trägt, von einer Heizeinrichtung (13) beheizt wird und um eine Drehachse (A) drehangetrieben wird, wobei an lokal beschränkten Stellen die Temperatur des Suszeptors (5) mit der Drehbewegung synchronisiert beeinflusst wird, **dadurch gekennzeichnet, dass** die Wärmeleiteigenschaften eines zwischen dem Suszeptor (5) und einem Temperieraggregat angeordneten Mediums lokal und periodisch gepulst verändert wird.

11. Verfahren nach Anspruch 10, **dadurch gekennzeichnet, dass** die Mittel (14, 14') im Bereich einer Wärmebeeinflussungszone (17) angeordnet sind, wobei die Wärmebeeinflussungszone (17) ein bezogen auf die Suszeptor-Drehachse (A) radial innerhalb oder außerhalb oder auf einer Umlaufbahn der Substrathalter-Drehachse (B) um die Suszeptor-Drehachse (A) angeordneter Bereich ist.

12. Verfahren nach einem der Ansprüche 10 oder 11, **dadurch gekennzeichnet, dass** dem Suszeptor (5) an örtlich beschränkten Wärmebeeinflussungszonen (17) entweder periodisch mit der Umlaufzeit des Suszeptors (5) für Zeiten kleiner als die Umlaufzeit oder für Zeiten länger als die Umlaufzeit des Suszeptors (5) mehr Wärme zu- oder abgeführt wird, als an daran angrenzenden Bereichen des Suszeptors (5), oder dass Mittel hierzu eingerichtet sind.

13. Verfahren nach einem der Ansprüche 10 bis 12, **dadurch gekennzeichnet, dass** durch eine Einspeiseöffnung (14') in einen Spalt (10) zwischen Suszeptor (5) und einem Temperieraggregat oder einem Kühlaggregat (30) entweder periodisch gepulst oder mit einem konstanten Fluss ein Temperiergas eingespeist wird und/oder dass ein Temperiergas mit periodisch wechselnden Wärmeleiteigenschaften in einen Spalt (10) zwischen Suszeptor (5) und Temperieraggregat eingespeist wird und/ oder dass an der Einspeiseöffnung (14') eine Gaszuleitung (14) mündet, in die mittels eines Umschaltventils (28) wahlweise ein Gas mit einer hohen Wärmeleitfähigkeit oder ein Gas mit einer geringeren Wärmeleitfähigkeit einspeisbar ist oder eingespeist wird.

14. Verfahren nach einem der Ansprüche 10 bis 13, **dadurch gekennzeichnet, dass** der Spalt (10) von einer zwischen der Heizeinrichtung (13) und der Unterseite des Suszeptors (5) angeordneten Dichtplatte (8) ausgebildet wird, durch den ein permanenter erster Gasfluss (S1) eines Spülgases hindurchströmt, in welchen ersten Gasfluss (S1) ein zweiter Gasfluss (S2) eines Temperiergases eingespeist wird, wobei der erste Gasfluss (S1) und der zweite Gasfluss (S2) einen dritten Gasstrom (S3) zwischen einem Substrathalter (7) zur Lagerung eines Substrates und einer Heizeinrichtung (13) bildet, dessen Fließgeschwindigkeit größer ist, als die Umfangsgeschwindigkeit des Suszeptors (5) am radial äußeren Rand des Substrathalters (7).

15. Verfahren nach einem der vorhergehenden Ansprüche, **dadurch gekennzeichnet, dass** das Temperiergas bezogen auf die Suszeptor-Drehachse (A) eine radial einwärts gerichtete oder radial auswärts gerichtete Strömungsrichtung besitzt.

## Claims

1. Device for the thermal treatment of substrates, with a susceptor (5) that can be heated by a heater (13), and can be rotated about a susceptor axis of rotation (A) by a rotary drive (20), and which has at least one substrate holder (7) for the reception of at least one substrate, with means (14, 14') for influencing the temperature of the susceptor (5) in a locally limited manner, and in a manner synchronised with the rotary movement of the susceptor (5), **characterised in that**, the means periodically alter in a pulsed manner the thermal conductivity of a medium arranged between the susceptor (5) and a temperature control unit.

2. Device according to claim 1, **characterised in that** the means (14, 14') are arranged in the area of a thermal influenced zone (17), wherein the thermal influence zone (17) with respect to the susceptor axis of rotation (A), the thermal influence zone (17) is a region radially inwards from, or outwards from, or on, an orbital path of the substrate holder axis of rotation (B) about the susceptor axis of rotation (A).

3. Device according to one of the preceding claims, **characterised in that**, the temperature control unit is a cooling unit (30), and/or **in that**, the temperature control unit is formed by a cooling channel of an RF induction coil (13), wherein an electromagnetic alternating field is generated with the RF induction coil (13), which field induces eddy currents in the susceptor (5), made of an electrically conductive material, for purposes of heating the latter.

4. Device according to one of the preceding claims, **characterised by** a feed opening (14') in a gap (10) between susceptor (5) and a temperature control unit or a cooling unit (30), through which a temperature control gas can be fed either periodically in a pulsed manner, or with a constant flow or at which a gas supply line (14) opens out, into which a gas with a high thermal conductivity, or a gas with a lower thermal conductivity can be fed selectively by means of a switchover valve (28).

5. Device according to Claim 4, **characterised in that**, the gap (10) is formed by a sealing plate (8) arranged between the heater (13) and the lower face of the susceptor (5).

6. Device according to one of the claims 2 to 5, **characterised in that**, a plurality of thermal influence zones (17) are provided, in which heat is periodically supplied or removed in a pulsed manner, wherein the thermal influence zones (17) are arranged at azimuthal angles that differ from one another, with respect to the centre of the susceptor (5), wherein the thermal influence zone (17) is limited to an angular range around the axis (A) of a maximum of 90 degrees, 60 degrees, 45 degrees, 30 degrees or 15 degrees and/or are arranged at different radial distances, with respect to the centre of the susceptor (5).

7. Device according to one of the claims 2 to 6, **characterised in that**, at least one thermal influence zone (17), in which heat is periodically supplied or removed in a pulsed manner, is arranged in a peripheral region around the centre of the susceptor (5), in which a plurality of substrate holders are located.

8. Device according to one of the preceding claims, **characterised by**, temperature measurement points (31, 31') arranged radially outwards from, and/or radially inwards from, a thermal influence zone, for purposes of measuring the temperature of a surface of the susceptor (5).

9. Device according to one of the claims 4 to 8, **characterised in that**, a plurality of feed openings (14') are provided at radial distances that differ from one another with respect to the susceptor axis of rotation (A), wherein one or a plurality of temperature control gases can be fed through one or a plurality of feed openings (14') as required.

10. Method for the thermal treatment of substrates, in which a susceptor (5) supports at least one substrate, is heated by a heater (13), and is driven in rotation about an axis of rotation (A), wherein the temperature of the susceptor (5) is influenced at locally limited points in a manner synchronised with the rotary movement, **characterised in that**, the heat conduction properties of a medium arranged between the susceptor (5) and a temperature control unit are altered locally and periodically in a pulsed manner.

11. Method according to Claim 10, **characterised in that**, the means (14, 14') are arranged in the area of a thermal influenced zone (17), wherein the thermal influence zone (17) with respect to the susceptor axis of rotation (A), the thermal influence zone (17) is a region radially inwards from, or outwards from, or on, an orbital path of the substrate holder axis of rotation (B) about the susceptor axis of rotation (A).

12. Method according to one of the claims 10 or 11, characterized that, more heat is supplied to, or removed from, the susceptor (5) at locally limited thermal influence zones (17) either periodically with the rotation time of the susceptor (5) for times shorter than the rotation time, or for times longer than the rotation time of the susceptor (5), than in regions of the susceptor (5) adjacent thereto, or in that, means are set up for this purpose.

13. Method according to one of the claims 10 to 12, **characterised in that**, a temperature control gas is fed through a feed opening (14') into a gap (10) between the susceptor (5) and a temperature control unit, or a cooling unit (30), either periodically in a pulsed manner, or with a constant flow, and/or **in that**, a temperature control gas with periodically changing thermal conductivity properties is fed into a gap (10) between the susceptor (5) and the temperature control unit, and/or **in that**, a gas supply line (14) opens into the feed opening (14'), into which line, by means of a switchover valve (28), a gas with a high thermal conductivity, or a gas with a lower thermal conductivity can be fed, or is fed, as required.

14. Method according to one of the claims 10 to 13, **characterised in that**, the gap (10) is formed by a sealing plate (8) arranged between the heater (13) and the lower face of the susceptor (5), through which passes a constant first gas flow (S1) of a purge gas, into which first gas flow (S1) a second gas flow (S2) of a temperature control gas is fed, wherein the first gas flow (S1) and the second gas flow (S2) form a third gas flow (S3) between a substrate holder (7) for purposes of supporting a substrate and a heater (13), the flow velocity of which is greater than the peripheral velocity of the susceptor (5) at the radially outer edge of the substrate holder (7).

15. Method according to one of the preceding claims, **characterised in that**, the temperature control gas has a direction of flow directed radially inwards, or radially outwards, with respect to the susceptor axis of rotation (A).

## Revendications

1. Dispositif de traitement thermique de substrats avec un suscepteur (5) pouvant être chauffé par un dispositif de chauffage (13) et pouvant tourner par un entraînement en rotation (20) autour d'un axe de rotation de support (A), qui comporte au moins un support de substrat (7) pour loger au moins un substrat, avec des moyens (14, 14') pour la modification localement limitée et synchronisée avec le mouvement de rotation du suscepteur (5) de la température du suscepteur (5), **caractérisé en ce que** les moyens modifient par pulsions périodiques la propriété thermoconductrice d'un milieu disposé entre le suscepteur (5) et un groupe de thermorégulation.

2. Dispositif selon la revendication 1, **caractérisé en ce que** les moyens (14, 14') sont disposés dans le secteur d'une zone de modification thermique (17), sachant que la zone de modification thermique (17) est, en référence à l'axe de rotation de support (A), une zone disposée radialement à l'intérieur ou à l'extérieur ou sur une orbite de l'axe de rotation du support de substrat (B) autour de l'axe de rotation de support (A).

3. Dispositif selon l'une quelconque des revendications précédentes, **caractérisé en ce que** le groupe de thermorégulation est un groupe réfrigérant (30) et/ou **en ce que** le groupe de thermorégulation est formé d'un conduit de refroidissement d'une bobine d'inductance RF (13), sachant qu'un champ alternatif électromagnétique est produit avec la bobine d'inductance RF (13), lequel induit des courants de Foucault dans le matériau électroconducteur du suscepteur (5) pour le chauffage de celui-ci.

4. Dispositif selon l'une quelconque des revendications précédentes, **caractérisé en ce qu'** à travers une ouverture d'alimentation (14') dans un interstice (10) entre le suscepteur (5) et un groupe de thermorégulation ou un groupe réfrigérant (30) à travers lesquels un gaz de thermorégulation est soit périodiquement pulsé, soit peut être introduit avec un flux constant ou sur laquelle débouche une conduite de gaz (14) dans laquelle un gaz à thermoconductivité élevée ou un gaz à thermoconductivité plus faible peut être introduit selon nécessités au moyen d'une vanne d'inversion (28) .

5. Dispositif selon la revendication 4, **caractérisé en ce que** l'interstice (10) est constitué par une plaque d'étanchéité (8) disposée entre le dispositif de chauffage (13) et la face inférieure du suscepteur (5).

6. Dispositif selon l'une quelconque des revendications 2 à 5, **caractérisé en ce que** plusieurs zones de modification thermiques (17) sont prévues, dans lesquelles de la chaleur est acheminée ou évacuée par pulsations périodiques, sachant que les zones de modification thermiques (17) sont disposées dans des angles azimutaux différents les uns des autres, en référence au centre du suscepteur (5), sachant que les zones de modification thermique (17) sont limitées à une zone angulaire autour de l'axe (A) d'un maximum de 90 degrés, 60 degrés, 45 degrés, 30 degrés ou 15 degrés et/ou sont disposées à des distances radiales différentes, en référence au centre du suscepteur (5).

7. Dispositif selon l'une quelconque des revendications 2 à 6, **caractérisé en ce qu'**au moins une zone de modification thermique (17), sur laquelle de la chaleur périodiquement pulsée est acheminée ou évacuée, est disposée dans un secteur périphérique autour du centre du suscepteur (5) dans lequel se trouve une pluralité de supports de substrat.

8. Dispositif selon l'une quelconque des revendications précédentes, **caractérisé par** des points de mesure de température (31, 31') disposés radialement vers l'extérieur et/ou radialement vers l'intérieur d'une zone de modification thermique pour la mesure de la température d'une surface du suscepteur (5).

9. Dispositif selon l'une quelconque des revendications 4 à 8, **caractérisé en ce que** plusieurs ouvertures d'alimentation (14') sont prévues à des distances radiales différentes les unes des autres par rapport à l'axe de rotation de support (A), sachant qu'un ou plusieurs gaz de thermorégulation peuvent être introduits selon nécessités à travers une ou plusieurs ouvertures d'alimentation (14').

10. Procédé de traitement thermique de substrats, pour lequel un suscepteur (5) porte au moins un substrat, est chauffé par un dispositif de chauffage (13) et est entraîné en rotation autour d'un axe de rotation (A), sachant qu'à des emplacements localement limités, la température du suscepteur (5) est influencée de façon synchronisée avec le mouvement de rotation, **caractérisé en ce que** les propriétés thermoconductrices d'un milieu disposé entre le suscepteur (5) et un groupe de thermorégulation sont modifiées par pulsions locales et périodiques.

11. Procédé selon la revendication 10, **caractérisé en ce que** les moyens (14, 14') sont disposés dans le secteur d'une zone de modification thermique (17), sachant que la zone de modification thermique (17) est, en référence à l'axe de rotation de support (A), un secteur disposé radialement à l'intérieur ou à l'extérieur ou sur une orbite de l'axe de rotation du support de substrat (B) autour de l'axe de rotation de support (A).

12. Procédé selon l'une quelconque des revendications 10 ou 11, **caractérisé en ce que** sur des zones de modification thermique localement limitées (17), une quantité de chaleur plus grande que sur les secteurs du suscepteur (5) limitrophes à celles-ci, est acheminée ou évacuée du suscepteur (5), soit périodiquement avec la durée de circulation du suscepteur (5) pour des temps plus faibles que la durée de circulation, soit pour des temps plus longs que la durée de circulation du suscepteur (5) ou **en ce que** des moyens sont agencés à cet effet.

13. Procédé selon l'une quelconque des revendications 10 à 12, **caractérisé en ce qu'**un gaz de thermorégulation est, soit périodiquement pulsé, soit introduit avec un flux constant à travers une ouverture d'alimentation (14') dans un interstice (10) entre le suscepteur (5) et un groupe de thermorégulation ou un groupe réfrigérant (30) et/ou **en ce qu'**un gaz de thermorégulation avec des propriétés thermoconductrices périodiquement variables est introduit dans un interstice (10) entre le suscepteur (5) et le groupe de thermorégulation et/ou **en ce qu'**une conduite de gaz (14) débouche sur l'ouverture d'alimentation (14') dans laquelle un gaz avec une thermoconductivité élevée ou un gaz avec une thermoconductivité plus faible peut être introduit ou est introduit selon nécessités au moyen d'une vanne d'inversion (28).

14. Procédé selon l'une quelconque des revendications 10 à 13, **caractérisé en ce que** l'interstice (10) est constitué par une plaque d'étanchéité (8) disposée entre le dispositif de chauffage (13) et la face inférieure du suscepteur (5) à travers lequel s'écoule un premier flux gazeux permanent (S1) d'un gaz de purge, premier flux gazeux (S1) dans lequel est introduit un deuxième flux gazeux (S2) d'un gaz de thermorégulation, sachant que le premier flux gazeux (S1) et le deuxième flux gazeux (S2) forment un troisième flux gazeux (S3) entre un support de substrat (7) pour positionner un substrat et un dispositif de chauffage (13) dont la vitesse d'écoulement est plus grande que la vitesse de circulation du suscepteur (5) sur le bord radialement extérieur du support de substrat (7).

15. Procédé selon l'une quelconque des revendications précédentes, **caractérisé en ce que** le gaz de thermorégulation possède une direction d'écoulement orientée radialement vers l'intérieur ou orientée radialement vers l'extérieur par rapport à l'axe de rotation du support (A).
